# EUROPEAN PATENT SPECIFICATION

(11) **EP 2 260 150 B1**
(45) Date of publication and mention of the grant of the patent: **08.04.2015**
(21) Application number: 09714648.4
(22) Date of filing: 27.02.2009
(51) Int. Cl.: E01F 7/04

(54) **A ROCKFALL PREVENTION METHOD**
VERFAHREN ZUR VERHINDERUNG VON STEINSCHLAG
PROCÉDÉ DE PRÉVENTION DES CHUTES DE PIERRES

(30) Priority: 27.02.2008 JP 2008045936
(43) Date of publication of application: 15.12.2010
(73) Proprietor: OFFICINE MACCAFERRI S.p.A., 40069 Zola Predosa (BO) (IT)
(72) Inventor: FUJII, Tomohiro, Niigata 957-0106 (JP); NOMURA, Toshimitsu, Niigata 957-0106 (JP)
(74) Representative: Provvisionato, Paolo
(86) International application number: PCT/IB2009/050809
(87) International publication number: WO 2009/107104

(56) References cited:
- EP-A1- 0 428 848
- WO-A1-99/43894
- WO-A1-2005/038143
- JP-A- 2000 027 123
- JP-A- 2002 088 765
- JP-A- 2007 231 700
- BALASINGAM MUHUNTHAN ET AL: "DESIGN GUIDELINES FOR WIRE MESH/CABLE NET SLOPE PROTECTION", TECHNICAL REPORT STANDARD,, no. WA-RD 612.2, 1 April 2005 (2005-04-01) , pages 1-60, XP007919833,

## Description

This invention is related to a rockfall prevention method.

Conventionally, it is known a method as this kind of rockfall prevention structure which drives an anchor into a slope that needs stabilization (as in JP Un-Examined Patent Publication No. 2007-262734) and, also it is known a method that covers a slope, using a net assembly constructed of combined vertical and horizontal rope materials, and a net covering such combined vertical and horizontal rope materials, and then fixes the net assembly to the slope by fixing the upper ends of the vertical rope materials and both ends of the horizontal rope materials to the slope through a buffering tool (as in JP Un-Examined Patent Publication No. JP 2002-227140).

According to the method in JP 2007-262734, it is possible to restrain the slope surface from collapsing. If, however, there are any joints (cracks or crevices) in a rock bed surface and thus specific masses of rock involving such joints have the potential to fall off, it is not possible to prevent the falling of such specific masses of rock.

On the other hand, according to the method in JP 2002-227140, it is possible to trap the fallen rock mass within its net assembly, should the rock mass fall, without getting its net assembly damaged by way of the buffering effect of the buffering tool and therefor it is possible to prevent the fallen rock mass from falling outside its net assembly. However, it is unable to capture the earth and sand released together with the falling identified rock mass, causing a concern that the released earth and sand may fall onto areas such as roads below the protective structure. At the same time, the method is difficult for use at sites where there is fear that the whole surface may collapse because when a identified rock mass falls, other rock masses surrounding the fallen identified rock mass tend to fall easily.

Moreover, identified rock masses that may easily fall are not distributed evenly throughout the slope but are unevenly distributed at each slope. Accordingly, the method that fixes the anchors at nearly equal intervals as is conventionally done has ample room for improvement in terms of economic point of view.

Technical report by Balasingam Muhunthan et al. "Design Guidelines for wire mesh/cable net slope protection", April 2005, discloses a methodology for designing wire mesh and cable net systems to control rockfall on steep slopes.

Henceforth, this invention aims to provide a rockfall prevention method that is able to prevent the collapse of slope surface and the falling of identified rock masses. Besides that, this invention also aims to provide a rockfall prevention method equipped with the required strength through economical design never performed in the past.

The invention as claimed in Claim 1 is a rockfall prevention method that covers a slope by a net assembly comprising rope members combined in intersectional directions and a wire net connected to the rope members, said net assembly being fixed to the slope by a fixing means, characterized in that it comprises the steps of: identifying a rock mass that protrudes out from the slope and is likely to fall; selecting anchors and net assembly for use and setting intervals of said anchors on the basis of slope data, geologic data and joint data of said identified rock mass, wherein said selection and setting are carried out every one block, said one block being defined by an area of said net assembly covering said identified rock mass surrounded by said anchors;inserting anchors for each block at varying intervals into the slope to stabilize a surface layer of the slope; and allowing said anchors and said net assembly to suppress the movement of said identified rock mass in the slope.

The invention as claimed in Claim 2 is the rockfall prevention method wherein the wire net comprises an array of longitudinal wires arranged side by side and each intertwined with at least one respective adjacent longitudinal wire, the rope members being intertwined or interlaced with at least one adjacent wire material of the wire net.

The invention as claimed in Claim 3 is the rockfall prevention method wherein the length of the said anchor to be inserted is 2 meters or more.

The invention as claimed in Claim 4 is the rockfall prevention method wherein a secondary net is laid on top of said net assembly, and said secondary net is fixed to the slope.

The invention as claimed in Claim 5 is the rockfall prevention method wherein a vegetation mat is provided on the slope.

Based on the configuration claimed in Claim 1, the anchor will prevent the slope surface from collapsing and at the same time, the anchor and the net assembly will suppress the movement of identified rock masses at the slopes and present them from falling.

Based on the configuration claimed in Claim 3, it will provide the effectiveness to prevent the surface layer from collapsing.

Based on the configuration claimed in Claim 4, the secondary net will partially reinforce the net assembly covering the slope which will be effective in restraining movement of identified rock masses.

Based on the configuration claimed in Claim 5, the slope will be able to be vegetated by the vegetation mat.

Based on the present invention, there can be provided a method to prevent rockfall using the anchor to prevent the slope surface from collapsing and at the same time using the anchor and the net assembly to suppress the movement of identified rock masses at the slope.

Based on the present invention, an anchor and net assembly that suit the slope conditions can be set using the data and a structure that suits the slope conditions can be provided through the setting of anchor interval.

Based on the present invention, a structure that suits the various conditions of each block can be provided.

Based on the present invention, a design that better meets the conditions can be provided by decreasing or increasing anchor intervals at areas having greater or smaller potential impact from identified rock masses respectively.

The preferred modes for carrying out the invention will be explained with reference to the attached drawings. Wherein:
Fig. 1 is a sectional view of the rock fall prevention structure according to the first embodiment of the invention.
Fig. 2 is a perspective view explaining the rock fall prevention structure according to the first embodiment of the invention.
Fig. 3 is an enlarged view showing the net according to the first embodiment of the invention.
Fig. 4 is a flow chart of the design method according to the first embodiment of the invention.
Fig. 5 is a sectional view explaining the identified rock masses according to the first embodiment of the invention.
Fig. 6 is a front view showing the rock fall prevention structure according to the first embodiment of the invention.
Fig. 7 is a front view showing the main elements of the net assembly according to the second embodiment of the invention.
Fig. 8 is a front view showing the main elements of the net assembly according to the third embodiment of the invention.
Fig. 9 is a front view showing the secondary net showing the fourth embodiment of the invention.
Fig. 10 is a front view showing the main elements of the secondary net according to the fourth embodiment of the invention.
Fig. 11 is a front view showing the rock fall prevention structure according to the fourth embodiment of the invention.
Fig. 12 is a sectional view showing the main elements of the rock fall prevention structure main elements according to the fifth embodiment of the invention.

Notwithstanding that, the embodiments explained hereunder shall not be construed to limit the contents of the invention as described in the patent claims. Similarly, all configurations explained hereunder are not necessarily the pre-requisites of this invention. Each embodiment explained hereafter describes the rockfall prevention method that is not found in prior art and is obtained from the application of a new rockfall prevention method that is different from the prior art.

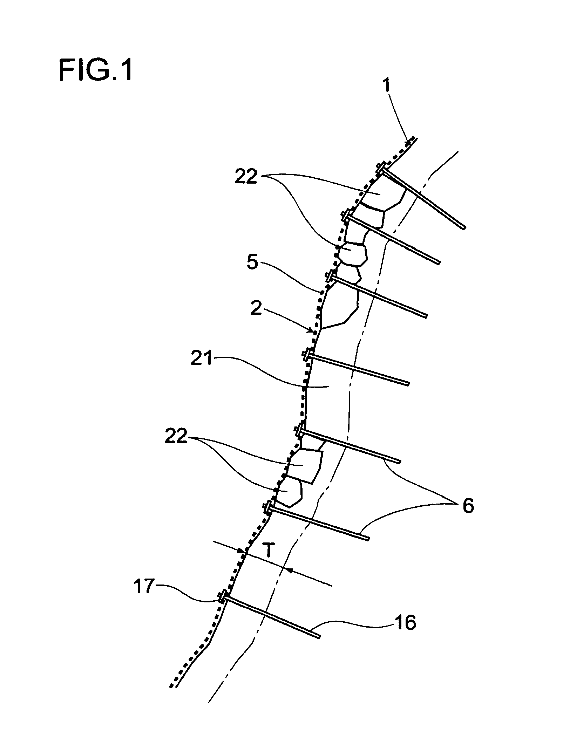

A first embodiment of the invention will be explained in reference to Fig. 1 to Fig. 6. As shown in the drawings, the rockfall prevention method uses a net assembly 2 to cover a slope 1, where the net assembly 2 is constructed of vertical and horizontal rope materials 3,4 combined in intersectional directions and a wire net 5 that are connected to these rope materials 3, 4 to cover the same, thus covering the slope 1 with these vertical and horizontal rope materials 3, 4, which are then fixed to the slope 1, using an anchor 6 serving as an anchoring means. In the meantime, the rope materials have greater strength than the wire materials of the net.

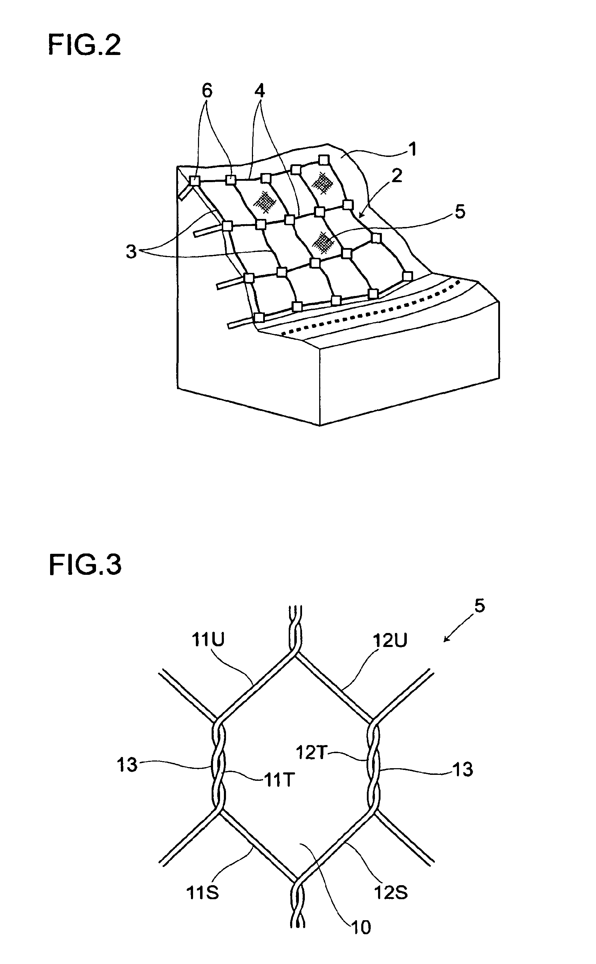

In Fig. 3, the wire net 5 includes a tortoise shell-shaped oblong hexagonal mesh 10. Its basic unit comprises: a wire material 11 at the left constructed of a top slant 11U, a vertical side 11T and a bottom slant 11S at one-side of the hexagon; a wire material 12 at the other side constructed of a top slant 12U, a vertical side 12T and a bottom slant 12S at the other side of the hexagon; and twist-joining points 13 and 13 where the wire materials 11 and 12 of the respective basic units are twisted at the top and bottom of the mesh 10 while the wire materials 11 and 12 of the adjoining basic units are twisted together with the said vertical side 11T at one side and 12T at the other side. In the meantime, the wire materials 11 and 12 are twisted twice or more in these twist-joining points.

For example, even if the top slant 110 is cut, the top and bottom twist-joining points 13 and 13 are still connected to the top slant 12U, vertical side 12T and bottom slant 12S of the other side, and thus it is advantageous because the overall net assembly will not break even if some part of the hexagonal shapes were cut.

The said anchor 6 is made of parts such as a steel rod 16 that is inserted into prepared drilled holes in slope 1 which is then entrenched into slope 1 using fixing materials such as grouting material. The anchor 6 includes an anchor plate 17 at its distal end to hold the wire net 5. In order to stabilize 0.5 to 1.5 meters thickness T of the surface layer 21, the length of the anchor to be inserted will be 2 meters or more, which, in this embodiment, is 3 meters. In other words, the anchor 6 is inserted up to a stable layer below the surface layer 21.

Although the anchoring point of the net assembly 2 using anchor 6 can be at any points, it is preferred that the net assembly 2 is anchored on the rope materials 3 and 4. If the anchor 6 is settled at the intersection of the rope materials 3 and 4, both rope materials 3 and 4 can be anchored.

Next, the design method of the said rockfall prevention structure will be explained.

According to this invention, the types of the anchor 6 and net assembly 2 to be used are determined after the conditions of slope 1 are carefully examined, to thereby stabilize the surface layer 21 and suppress the movement of the identified rock mass 22 at the surface of the slope 1. Here, the wording "suppressing the movement" means preventing the dislodgement and consequently the falling of identified rock mass 22 by identifying the rock mass 22 that is likely to fall due to cracks or other causes so that the movement of the identified rock mass 22 from its present position can be prevented. Here, the term "identified rock mass 22" refers to a relatively large rock mass that protrudes out from slope 1 and is predicted to fall because of the conditions at the rock joint.

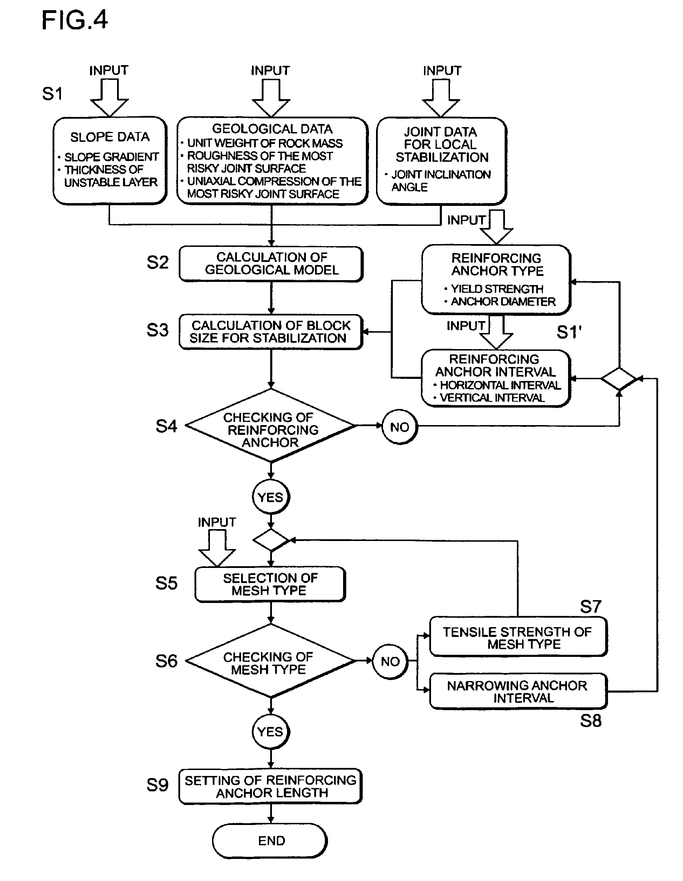

As shown in Fig. 4, the site data must first be examined and set before the designing is carried out. In data input (S1: Step 1), "slope data", "geological data" and "joint data" are input, where slope gradient θ, thickness T of the unstable surface layer 22, etc. are input as "slope data"; unit weight of a rock mass on the slope 1, roughness of the most risky joint (crack), the uniaxial compression strength of the most risky joint surface 23, etc. are input as "geological data"; and the joint inclination angle a is input as "joint data for local stabilization".

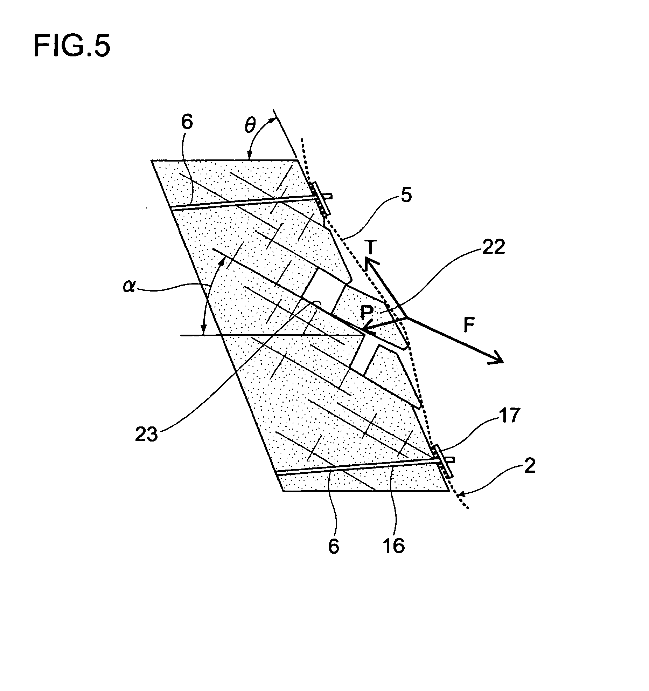

Based on each of the above data, "calculation of geological model" (S2: Step 2) is carried out to thereby calculate the force that will be applied to the net assembly 2 if the identified rock mass 22 on slope 1 were to suddenly fall, as shown in Fig. 5. As illustrated in this drawing, the inclination angle α of the joint surface 23 and the weight of the identified rock mass 22 are used to calculate the load that will be applied to the net assembly 2 and anchor 6, where F denotes the design load of the identified rock mass moving in the direction of the joint surface 23, T denotes a reactive force against the tension occurring in the stretching direction of the net assembly 2, and P denotes a reactive force of the force applied vertically to the slope 1 by the design load F, where the reactive forces T and P counterbalance against the design load F. The area surrounded by the said anchors is called one block.

Next, the "calculation of block size for stabilization" (S3: Step 3) is performed where the data obtained from the above "calculation of geological model" (S2) is used to calculate and set the interval for anchor 6. The setting data for "reinforcing anchor type" and "reinforcing anchor interval" are input in advance (S1': Step 1') such as the yield strength or diameter of the anchor 6 for "reinforcing anchor type" and horizontal and vertical intervals for "reinforcing anchor interval". In the meantime, the terms "reinforcing anchor" and "mesh" used in the drawings refer to the anchor 6 and the net assembly 2, respectively.

Once the various conditions of the anchor 6 are set, the "checking of reinforcing anchor" (S4: Step 4) is performed, where the data derived from the above Step 3 and Step 1' are used to examine if the anchor 6 set in Step 1' meets the requirements. If the requirements are not met, the procedure must be retraced to Step 1' where the setting data are reset, and then return to Step 3 and undergo re-checking at Step 4. If the requirements of anchor 6 are met there, the procedure progresses to "setting of mesh" (S5: Step 5), in which the type of mesh is set, or in other words, the type of the net assembly 2 to be used is selected and then, the data for the net assembly 2, i.e., the data for the wire net 5, vertical and horizontal rope materials 3 and 4 are input.

Next, the "checking of mesh type" (S6: Step 6) is carried out to determine whether the net assembly 2 selected in Step 5 meets the design requirements, in such a manner as: determining whether the net assembly 2 meets the required strength against the reactive forces T and P calculated based on calculations such as anchor interval determined in Step 1' under "calculation of geological model" in Step 2. If not, progressing either to "tensile strength of mesh type" (S7: Step 7) where the conforming tensile strength of the net assembly 2 in Step 5 is input again or to "narrowing anchor interval" (S8: Step 8) where the data in Step 1' is re-input. As the force applied to the net assembly 2 can be reduced if the interval of the anchors 6 is reduced, the requirements in Step 6 can be met by changing the parameters both in Step 7 and in Step 8 or either in Step 7 or in Step 8 if they are not met initially.

If the net assembly 2 does not meet the requirements in Step 6, the requirements may be met in Step 7 by re-selecting all or at least one of the options such as re-selecting a wire net 5 with higher strength, increasing the strength of both or either one of the vertical and horizontal rope material 3 and/or 4, or narrowing the gap of both or either one of the vertical and horizontal rope materials 3 and 4.

Once the net assembly 2 that meets the requirements are set through the checking in Step 6, the step progresses and ends at "setting of reinforcing anchor length" (S9: Step 9) where the length of anchor 6 for the stabilization is determined according to site conditions such as the thickness of surface layer 22 and the gradient of slope 1.

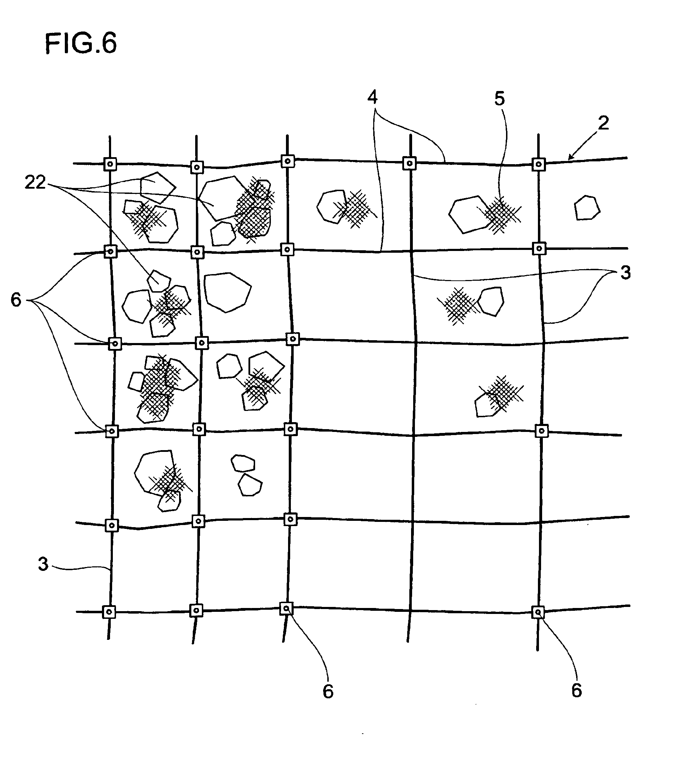

As illustrated in Fig. 6, for example, the interval for anchors 6 can be made narrower for the block in which the identified rock masses 22 are comparatively large or many, while it can be made wider for the block in which the identified rock masses 22 are comparatively small or few. Therefore, in Fig. 6, in contrast to the vertical rope material 3 at the left of the drawing that has been fixed by the anchor 6 at all of its intersections, the vertical rope material 3 at the right side of the drawing is not fixed by the anchor 6 at its second and fourth level when seen from the bottom level because there is no necessity to provide any fixing anchors at those locations.

Therefore, there is provided the rockfall prevention method such that the slope 1 is covered with the net assembly 2 constructed of the rope materials 3 and 4 combined in the intersectional directions and the wire net 5 connected thereto and then the net assembly 2 is fixed to the slope 1, wherein the anchors 6 are inserted into the slope 1 in order to stabilize the surface layer 21 of the slope 1, and the anchors 6 and the net assembly 2 serve to suppress the movement of identified rock masses 22 at the slope 1, whereby the anchors 6 can prevent the collapse of the surface layer 21 of the slope 1, at the same time, the anchors 6 and the net assembly 2 can suppress the movement of identified rock masses 22 at the slope 1, thus enabling the identified rock masses 22 to be prevented from falling from the slope 1.

Also, it is effective in preventing the surface layer 21 from collapsing because the insertion length of the anchor 6 is 2 meters or more in this embodiment.

Also, selection of the anchor 6 and net assembly 2 for use as well as setting of the intervals of anchors 6 is made based on the slope data, geological data and rock joint data of the identified rock masses 22, and thus, the specific anchor 6 and net assembly that meet the conditions of the slope 1 can be set based on various data., further enabling the provision of the structure that meets the conditions of the slope 1 by setting the interval of the anchors 6.

Also, the aforesaid selection and setting are made with the area of the net assembly 2 surrounded by the anchors 6 as one block, and thus there can be provided a structure that meets varying conditions of each block.

The anchors 6 are arranged at varying intervals, and thus a design that better meets the requirements can be provided. For example, if the force from the identified rock mass 22 at certain area is greater, the interval of anchor 6 at that area may be made narrower. If the force is smaller, the interval of anchor 6 at that area may be made wider.

Also, as effects of the invention, an efficient designing can be carried out because conditions such as the interval of anchor 6 can be changed as and when required during the selection and checking of the net assembly 2 in such a manner that after setting conditions of the anchor 6 such as strength and interval thereof that meet the conditions of slope 1, selection and checking of the net assembly 2 are carried out that meets the working conditions under the conditions of the anchor 6 thus set and the conditions of the slope 1, and then, the interval of anchor 6 is re-selected to make it narrower during the selection of net assembly 2 if such working conditions of the net assembly 2 turn out to fail to be met.

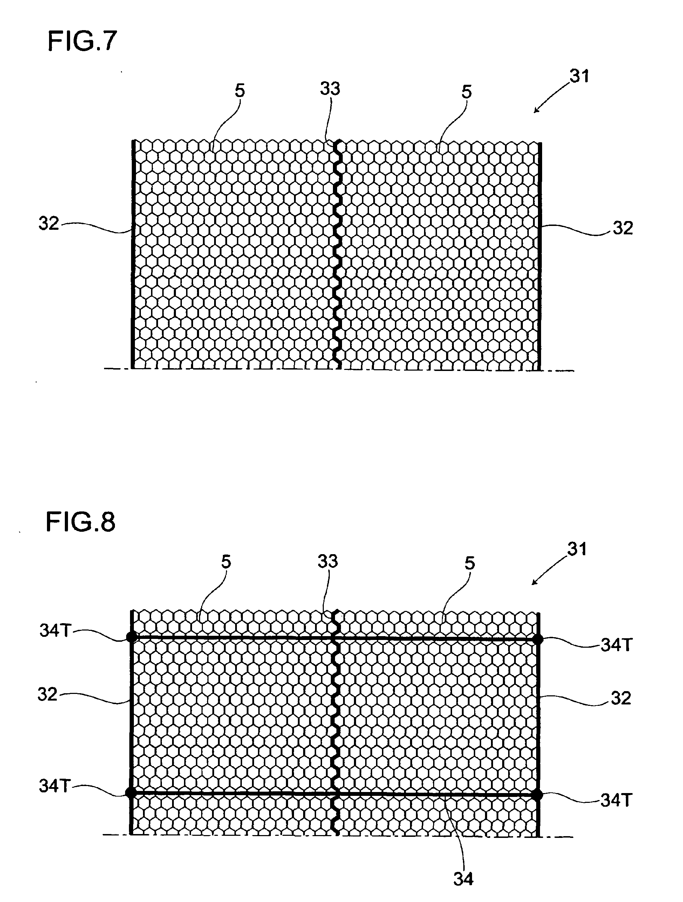

Fig. 7 illustrates a second embodiment of a rockfall prevention structure, which will be described in detail with the same parts as in the foregoing embodiment being indicated using the same symbols and their detailed explanation being abbreviated. This embodiment shows a modified example of the net assembly 2 in which net formation 31 is used as a component material of the above-mentioned net assembly 2. The net formation 31 comprises an array of longitudinal wires 11 and 12 arranged side by side and each intertwined with at least one respective adjacent longitudinal wire. The net formation 31 further comprises one or more longitudinal rope materials arranged between two adjacent wires material 11 and 12, and/or rope materials 32 arranged beside one wire material, for example, at the left and right edges of the net formation 31. In both cases, the vertical sides 11T and/or 12T of the wire materials 11 and/or 12 are twisted on the rope materials so that the longitudinal rope materials are intertwined or interlaced with at least one adjacent wire material 11 or 12. A connecting wire material 33 night be provided at the centre of the wire net 5 to join the two pieces of the wire net 5 at left and right sides where the connecting wire material 33 has the same construction as the above-mentioned wire materials 11 and 12. The rope material 32 and 33 may also comprise twisted portions which are engaged with the longitudinal wire materials of the net formation 31.

The said net formation 31 is placed on the vertical direction of slope 1 as well as on the horizontal direction of slope 1 where adjoining net formations 31 and 31 on the horizontal direction of the slope 1 are connected using a connecting material (not shown in the drawing) at both of its guide rope materials 32 and 32, followed by the placement of the horizontal rope materials 4, and if needed by design requirements, the vertical rope materials 3 are placed before they are anchored by anchor 6 at required locations to thereby construct a rockfall prevention structure.

The said guide rope materials 32 may be used as the vertical rope materials so that the guide rope materials 32 may be anchored into the slope 1 using the anchors 6. In that case, as the vertical guide rope materials 32 are provided beforehand, the number and/or length of the vertical rope materials 3 used can be reduced and the strength of the vertical rope materials 3 used can be saved.

Fig. 8 illustrates a third embodiment of a rockfall prevention structure, which will be described in detail with the same parts as in the foregoing embodiments being indicated using the same symbols and their detailed explanation being abbreviated. In this embodiment, a horizontal guide rope material 34 is provided on the above-mentioned net formation 31. Specifically, a plurality of these horizontal guide rope materials 34 are arranged at certain intervals in a lengthwise direction of the net formation 31 and are jointed to the above-mentioned vertical guide rope material 32 at both ends using annular connecting materials 34T.

The horizontal guide rope material 34 are intertwined or interlaced, throughout their length or for only part thereof, with the wire material 11 and 12 and/or with the longitudinal rope materials and are arranged outside intertwining regions 13 defined by two twisted portions 11T and 12 T of wires 11 and 12 and/or by the portions of longitudinal rope materials. The said net formation 31 is placed on the vertical direction of slope 1 as well as on the horizontal direction of slope 1 where adjoining net formations 31 and 31 on the horizontal direction of slope 1 are connected by a connecting material (not shown in the drawing) at both of its guide rope materials 32 and 32, and if needed by design requirements, the vertical rope material 3 and/or horizontal rope material 4 are also arranged which are then anchored by the anchors 6 at required locations to construct a rockfall prevention structure.

The said guide rope materials 34 may be used as the horizontal rope materials so that the guide rope materials 34 may be anchored into the slope 1 using the anchors 6. In that case, as the horizontal guide rope materials 34 are provided beforehand, the number and/or length of the horizontal rope materials 4 used can be reduced and the strength of the horizontal rope materials 4 used can be saved.

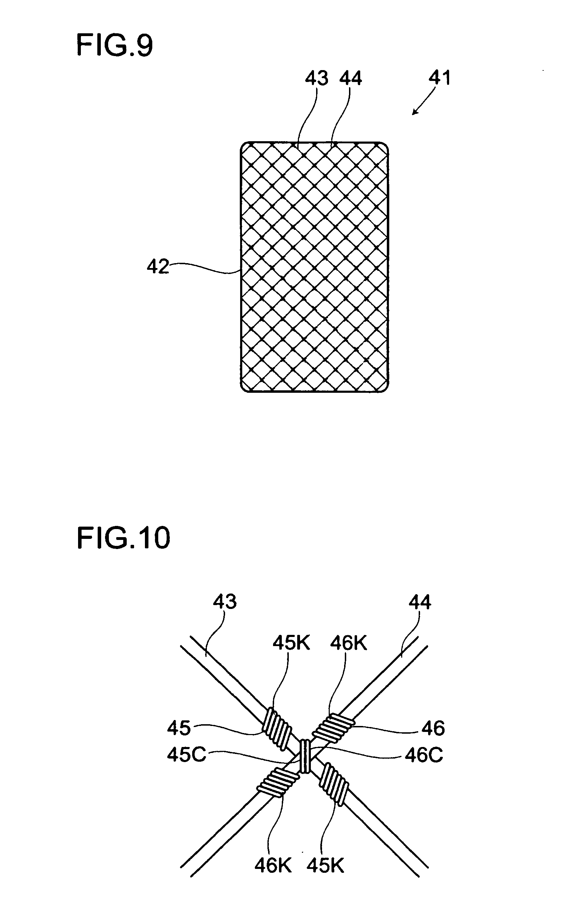

Figs. 9 to 11 illustrate a fourth embodiment of a rockfall prevention structure, which will be described in detail with the same parts as in the foregoing embodiments being indicated using the same symbols and their detailed explanation being abbreviated. In this embodiment, there is provided a secondary net 41 as a rectangular net formation, which is, according to needs, vertically and horizontally edged by perimeter rope materials 42 between which are provided crossing wire materials 43 and 44. In this embodiment, the crossing wire material 43 slant to one side, while the crossing wire material 44 slant to the other side. Alternatively, this type of secondary net 41 without the perimeter rope materials 42 may also be used.

At the intersection of the crossing wire materials 43 and 44, intersection connecting materials 45 and 46 are fixed to resist forces applied on the intersections that tend to shift the intersections in such a manner that both ends of one intersection connecting material 45 are provided with a fastening section 45K formed by winding the material 45 around the crossing wire material 43 in a coil form with the intersection of the crossing wire material 43 placed therebetween, and these fastening sections 45K are connected with each other via a central section 45C at the centre of the intersection connecting material 45, and similarly, both ends of the other intersection connecting material 46 are provided with a fastening section 46K formed by winding the other intersection connecting material 46 around the other crossing wire material 44 in a coil form with the intersection of the crossing wire material 44 placed therebetween, and these fastening sections 46K are connected with each other via a central section 46C at the centre of the intersection connecting material 46.

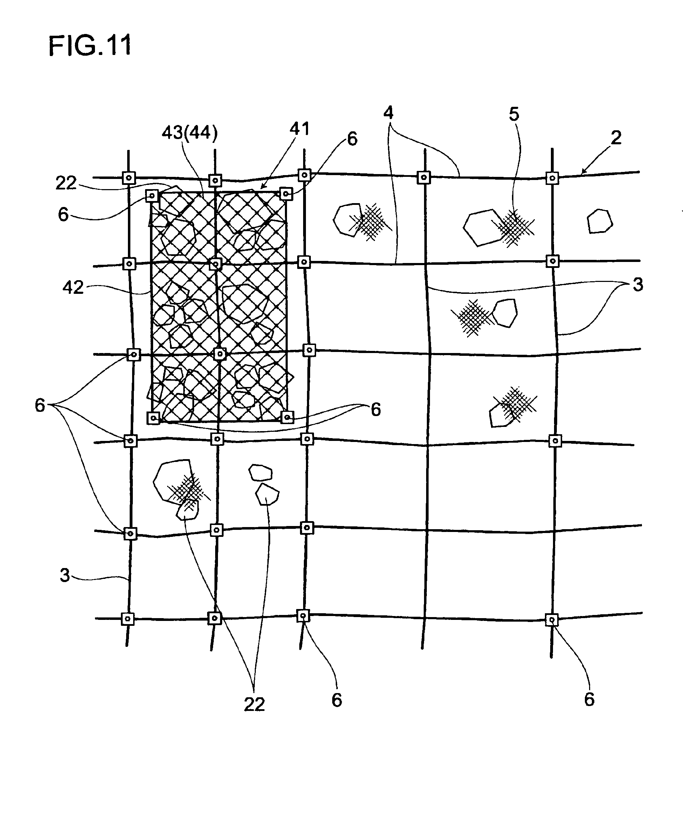

As shown in Fig. 11, the secondary net 41 is laid on top of a part of the net assembly 2 covering the blocks having larger or comparatively many identified rock masses 2, and the secondary net 41 is then fixed to the slope 1 by fixing the perimeter rope materials, crossing wire materials 43 and/or 44 relative to the slope or net assembly 2. It is preferred that the anchor 6 be used for the fixing, such that the perimeter rope material 42 is anchored to the slope 1 using the anchors 6. The secondary net 41 combined with the perimeter rope material 42 will provide a secondary net assembly in which the perimeter rope material 42 may construct the vertical and horizontal rope materials. The secondary net 41 may be placed either on top or underside of the net assembly 2.

As is apparent from the foregoing, according to the present embodiment, the secondary net 41 is able to effectively prevent the movement of the identified rock masses 22 as it partially reinforces the net assembly 2 covering over the slope 1 because the secondary net 41 is laid on top of a part of the net assembly 2 and is anchored to the slope 1 using the anchors 6 serving as the fixing means of the secondary net assembly.

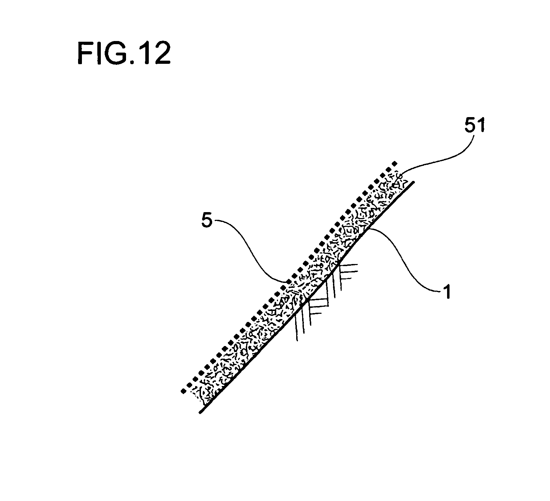

Fig. 12 illustrates a fifth embodiment of a rockfall prevention structure which will be described in detail with the same parts as in the foregoing embodiment being indicated using the same symbols and their detailed explanation being abbreviated. In this embodiment, there is provided the construction of the net assembly 2 with a vegetation mat on the slope 1 where the vegetation mat 51 is the one constituted of a three dimensional net-like synthetic plastic wire material with certain air voids brought about by its irregularly twisted wire material so as to be shaped like a loofa, for example, to thereby provide it with water retention property which is preferably laid directly on top of the slope 1 and under the net assembly 2.

By spraying seeds and if necessary, vegetation substrate material onto the said vegetation mat 51, the vegetation mat 51 will be able to nurture them and achieve vegetation.

Therefore, through the construction of the vegetation mat 51 on the above-mentioned slope, the vegetation mat 51 will be able to achieve vegetation on the slope 1.

This invention is not limited to the above embodiments but can also be embodied in various variations. For example, the secondary net 41 may also be spread over the overall surface of the slope 1 to improve the effectiveness in suppressing the movement of the identified rock masses 22 because the intersections of the crossing wire materials 43 and 44 of the secondary net 41 are provided with the intersection connecting materials 45 and 46 giving a net mesh that is difficult to break open. In the embodiments, apart from the horizontal and vertical rope materials shown, the rope materials can also be crossed diagonally.

## Claims

1. A rockfall prevention method that covers a slope (1) by a net assembly (2), comprising rope members (3,4) combined in intersectional directions and a wire net (5) connected to the rope members, said net assembly (2) being fixed to the slope (1) by anchors (6) positioned at the intersections of said rope members, **characterized in that** it comprises the steps of:
identifying rock masses (22) that protrude out from the slope and are likely to fall;
selecting anchors (6) and net assembly (2) for use and setting intervals of said anchors (6) on the basis of slope data, geologic data and joint data of said identified rock masses (22), wherein said selection and setting are also carried out every one block, said one block being defined by an area of said net assembly (2) covering an identified rock mass (22) surrounded by said anchors (6), varying the intervals of said anchors (6) according to the force from said identified rack mass (22);
inserting anchors (6) for each block at such varying intervals into the slope (1) to stabilize a surface layer of the slope (1) ; and allowing said anchors (6) and said net assembly (2) to suppress the movement of said identified rock mass (22) in the slope (1).

2. The rockfall prevention method according to Claim 1, wherein the wire net comprises an array of longitudinal wires arranged side by side and each intertwined with at least one respective adjacent longitudinal wire, the rope members being intertwined or interlaced with at least one adjacent wire material of the wire net.

3. The rockfall prevention method according to any one of Claims 1 to 2, wherein the length of the said anchors (6) to be inserted is 2 meters or more.

4. The rockfall prevention method according to any one of Claims 1 to 3, wherein a secondary net is laid on top of said net assembly, and said secondary net is fixed to the slope.

5. The rockfall prevention method according to any one of Claims 1 to 4 , wherein a vegetation mat is provided on the slope.

## Patentansprüche

1. Verfahren zur Verhinderung von Steinschlag, bei dem ein Hang (1) mit einer Netzanordnung (2) bedeckt wird, wobei die Netzanordnung (2) Seilelemente (3, 4), die in sich überschneidenden Richtungen verknüpft sind, und ein mit den Seilelemenlen verbundenes Drahtnetz (5) umfasst, wobei die Netzanordnung (2) an dem Hang (1) durch Anker (6), die an den Schnittpunkten der Seilelemente platziert sind, befestigt ist,
**dadurch gekennzeichnet**,
dass es die folgenden Schritte umfasst: Identifizieren von Felsmassen (22), die von dem Hang vorstehen und wahrscheinlich herunterfallen werden; Auswählen der Anker (6) und der Netzanordnung (2) für die Benutzung und Festlegen von Intervallen der Anker (6) auf der Grundlage von Hangdaten, geologischen Daten und Kluftdaten der identifizierten Felsmassen (22), wobei die Auswahl und das Festlegen auch für jeden einzelnen Block ausgeführt wird, wobei der einzelne Block durch einen Bereich der eine identifizierte Felsmasse (22) bedeckenden Netzanordnung (2), der von den Ankern (6) umgeben ist, definiert ist; Variieren der Intervalle der Anker (2) in Abhängigkeit der Kraft, die von der identifizierten Felsmasse (22) ausgeht; für jeden Block Einbringen von Ankern (6) in den Hang (1) in solchen variierenden Intervallen, um eine Oberflächenschicht des Hanges (1) zu stabilisieren; und Ermöglichen, dass die Anker (6) und die Netzanordnung (2) die Bewegung der identifizierten Felsmasse (22) an dem Hang (1) unterdrücken.

2. Verfahren zur Verhinderung von Steinschlag nach Anspruch 1, wobei das Drahtnetz eine Reihe von nebeneinander angeordneten längserstreckten Drähten umfasst und jeder Draht mit mindestens einem jeweils benachbarten längserstreckten Draht verschlungen ist, wobei die Seilelemente mit wenigstens einem Drahtmaterial des Drahtnetzes verschlungen oder verflochten sind.

3. Verfahren zur Verhinderung von Steinschlag nach Anspruch 1 oder 2, wobei die Länge der einzubringenden Anker (6) 2 Meter oder mehr ist.

4. Verfahren zur Verhinderung von Steinschlag nach einem der Ansprüche 1 bis 3, wobei ein zweites Netz auf die Netzanordnung gelegt wird und das zweite Netz an dem Hang befestigt wird.

5. Verfahren zur Verhinderung von Steinschlag nach einem der Ansprüche 1 bis 4, wobei eine Vegetationsmatte auf dem Hang vorgesehen ist.

## Revendications

1. Procédé de prévention des chutes de pierres qui recouvre une pente (1) par un montage de filet (2), comprenant des éléments de corde (3, 4) combinés dans des directions intersectionnelles et un treillis métallique (5) relié aux éléments de corde, le montage de filet (2) étant fixé à la pente (1) par des ancrages (6) positionnés aux intersections des éléments de corde, **caractérisé en ce qu'**il comprend les étapes :
d'identification de masses de pierres (22) qui font saillie de la pente et qui sont susceptibles de tomber ;
de sélection d'ancrages (6) et du montage de filet (2) pour utiliser et régler des intervalles des ancrages (6) sur la base de données de pente, de données géologiques et de données conjointes des masses de pierres (22) identifiées, dans lequel la sélection et le réglage sont également effectués sur chaque bloc, l'un bloc étant défini par une zone du montage de filet (2) couvrant une masse de pierres (22) identifiée entourée par les ancrages (6), en faisant varier les intervalles des ancrages (6) en fonction de la force venant de la masse de pierres (22) identifiée ;
d'insertion des ancrages (6) pour chaque bloc à de tels intervalles de variation dans la pente (1) pour stabiliser une couche de surface de la pente (1) ; et permettre aux ancrages (6) et au montage de filet (2) de supprimer le mouvement de la masse de pierres (22) identifiée dans la pente (1).

2. Procédé de prévention des chutes de pierres selon la revendication 1, dans lequel le treillis métallique comprend une rangée de fils longitudinaux agencés côte à côte et entrelacés chacun avec au moins un fil longitudinal adjacent respectif, les éléments de corde étant entrelacés avec au moins un matériau de fil adjacent du treillis métallique.

3. Procédé de prévention des chutes de pierres selon la revendication 1 ou 2, dans lequel la longueur des ancrages (6) à insérer est de 2 mètres ou plus.

4. Procédé de prévention des chutes de pierres selon l'une quelconque des revendications 1 à 3, dans lequel un filet secondaire est posé au-dessus du montage de filet, et le filet secondaire est fixé à la pente.

5. Procédé de prévention des chutes de pierres selon l'une quelconque des revendications 1 à 4, dans lequel un tapis de végétation est prévu sur la pente.
